# EUROPÄISCHE PATENTANMELDUNG

(11) **EP 2 551 855 A2**
(43) Veröffentlichungstag der Anmeldung: **30.01.2013**
(21) Anmeldenummer: 12172860.4
(22) Anmeldetag: 21.06.2012
(51) Int. Cl.: G11C 29/52, G11C 29/56, G11C 29/18

(54) **Vorrichtung und Verfahren zum Testen eines Speichers eines elektrischen Gerätes**

(30) Priorität: 26.07.2011 DE 102011079780
(71) Anmelder: HILTI Aktiengesellschaft, 9494 Schaan (LI)
(72) Erfinder: Beck, Wolfgang, 86987 Schwabsoien (DE)

(57) **Zusammenfassung**

Die erfindungsgemäße Vorrichtung zum Testen eines Speichers eines elektrischen Gerätes weist eine Steuereinrichtung, eine Testeinrichtung, einen Zwischenspeicher und einen Adressumsetzer auf. Die Steuereinrichtung ist mit dem Speicher gekoppelt und zum Steuern des elektrischen Gerätes eingerichtet. Die Testeinrichtung ist mit dem Speicher gekoppelt und zum Testen einer bestimmten Speicherzelle einer Vielzahl von Speicherzellen des Speichers eingerichtet. Der Zwischenspeicher ist zum Zwischenspeichern der in der bestimmten Speicherzelle gespeicherten Daten während des Testens der bestimmten Speicherzelle eingerichtet. Der Adressumsetzer ist zum Umsetzen der Adresse der bestimmten Speicherzelle auf die Adresse des Zwischenspeichers während des Testens der bestimmten Speicherzelle eingerichtet.

## Beschreibung

### GEBIET DER ERFINDUNG

Die vorliegende Erfindung betrifft eine Vorrichtung und ein Verfahren zum Testen eines Speichers eines elektrischen Gerätes. Der Speicher ist beispielsweise ein RAM-Speicher (RAM; Random-Access-Memory) und das elektrische Gerät ist beispielsweise eine Handwerkzeugmaschine, insbesondere eine elektrische Handwerkzeugmaschine, wie zum Beispiel ein Elektroschrauber.

Speichertests, wie z.B. zyklische RAM-Tests, sind im Rahmen verschiedener Normen zur Bereitstellung funktional sicherer Software gefordert. Ein Beispiel für eine solche Norm ist IEC 60730. Demnach müssen fehlerhafte Speicherzellen ermittelt werden. Nach der Ermittelung einer fehlerhaften Speicherzelle können entsprechende Sicherheitsmaßnahmen oder Notmaßnahmen eingeleitet werden.

Im Rahmen solcher RAM-Tests werden verschiedene Prüfmuster in eine RAM-Zelle geschrieben, zurückgelesen und auf Korrektheit geprüft. Diese Speichertests werden herkömmlicherweise von der Steuereinrichtung des elektrischen Gerätes durchgeführt, insbesondere von der auf der Steuereinrichtung implementierten Software. Eine solche Steuereinrichtung ist beispielsweise ein Microcontroller oder eine CPU (CPU; Central Processing Unit).

Damit ist nachteiligerweise ein gewisser Implementierungsaufwand für den Speichertest in der Software der Steuereinrichtung notwendig. Des Weiteren ist die Steuereinrichtung des elektrischen Gerätes durch die Durchführung der Speichertests belastet und kann zumindest zu gewissen Zeitpunkten sogar blockiert sein. Ferner kann es nachteiligerweise notwendig sein, für die Durchführung der Speichertests Interrupts zu sperren.

### OFFENBARUNG DER ERFINDUNG

Die erfindungsgemäße Vorrichtung zum Testen eines Speichers eines elektrischen Gerätes weist eine Steuereinrichtung, eine Testeinrichtung, einen Zwischenspeicher und einen Adressumsetzer auf. Die Steuereinrichtung ist mit dem Speicher gekoppelt und zum Steuern des elektrischen Gerätes eingerichtet. Die Testeinrichtung ist mit dem Speicher gekoppelt und zum Testen einer bestimmten Speicherzelle einer Vielzahl von Speicherzellen des Speichers eingerichtet. Die Testeinrichtung kann die Speicherzellen des Speichers nacheinander testen.

Der Zwischenspeicher ist zum Zwischenspeichern der in der bestimmten Speicherzelle gespeicherten Daten während des Testens der bestimmten Speicherzelle eingerichtet.

Dazu schreibt vorzugsweise die Testeinrichtung die in der bestimmten Speicherzelle gespeicherten Daten vor der Durchführung des Speichertests in den Zwischenspeicher.

Der Adressumsetzer ist zum Umsetzen der Adresse der bestimmten Speicherzelle auf die Adresse des Zwischenspeichers während des Testens der bestimmten Speicherzelle eingerichtet.

Erfindungsgemäß entfällt der herkömmliche Implementierungsaufwand für den Speichertest in der Software der Steuereinrichtung. Durch die dediziert vorgesehene Testeinrichtung wird die Steuereinrichtung entlastet. Des Weiteren ist die Steuereinrichtung durch die dediziert vorgesehene Testeinrichtung in ihrer Ausführung zu keinem Zeitpunkt blockiert, da die Steuereinrichtung während des Testens der bestimmten Speicherzelle auf die Daten der bestimmten Speicherzelle dadurch zugreifen kann, dass der Adressumsetzer einen Zugriff der Steuereinrichtung auf die bestimmte Speicherzelle auf den Zwischenspeicher umleitet, der die Daten der bestimmten Speicherzelle bereitstellt. Der Speicher ist beispielsweise ein RAM-Speicher oder ein FLASH-Speicher.

Die Adresse kann insbesondere als Speicheradresse bezeichnet werden. Der Speicher speichert insbesondere für die Steuerung des elektrischen Gerätes notwendige Steuerprogramme, auf welche die Steuereinrichtung zugreift. Auch Interrupts bleiben zu jedem Zeitpunkt möglich.

Die Speicherzelle kann eine beliebige Wortbreite aufweisen, z.B. 1 Bit, 4 Bit, 8 Bit, 16 Bit, etc. Die Steuereinrichtung kann beispielsweise als Microcontroller oder CPU des elektrischen Gerätes ausgebildet sein.

Bei einer Ausführungsform hat der Speicher eine einzige Schnittstelle, über welche die Steuereinrichtung, die Testeinrichtung und der Adressumsetzer mit dem Speicher gekoppelt sind. Die Schnittstelle ist beispielsweise eine Schnittstelleneinrichtung oder ein Port.

Bei einer weiteren Ausführungsform ist der Adressumsetzer zwischen der Schnittstelle des Speichers und der Steuereinrichtung sowie zwischen der Schnittstelle des Speichers und der Testeinrichtung gekoppelt.

Bei einer weiteren Ausführungsform ist ein Kommunikations-Bus vorgesehen ist, über welchen die Steuereinrichtung, die Testeinrichtung und der Adressumsetzer gekoppelt sind. Der Adressumsetzer ist mit der einzigen Schnittestelle des Speichers gekoppelt.

Bei einer weiteren Ausführungsform ist der Zwischenspeicher als eine vorbestimmte Speicherzelle des Speichers ausgebildet.

Beispielsweise hat der Speicher N Speicherzellen, wobei N-1 Speicherzellen für das Speichern von Daten, wie beispielsweise Ablaufprogramme, Steuerprogramme und dergleichen, genutzt werden können und wobei die verbleibende Speicherzelle als Zwischenspeicher dienen kann.

Bei einer weiteren Ausführungsform ist der Zwischenspeicher in dem Adressumsetzer integriert.

Durch die Integration des Zwischenspeichers in den Adressumsetzer können alle Speicherzellen des Speichers zum Speichern von Daten eingesetzt werden. Des Weiteren ergibt sich aus der Integration des Zwischenspeichers in den Adressumsetzer, dass der Adressumsetzer bei einem Zugriff der Steuereinrichtung auf die Daten der bestimmten Speicherzelle des Speichers während des Speichertests nicht auf den Speicher zugreifen muss, da der Adressumsetzer diese Daten in dem integrierten Zwischenspeicher bereits vorhält.

Bei einer weiteren Ausführungsform ist die Testeinrichtung zum Testen der bestimmten Speicherzelle dazu eingerichtet, die in der bestimmten Speicherzelle gespeicherten Daten in den Zwischenspeicher zu speichern, die bestimmte Speicherzelle mit einem Prüfmuster zu beschreiben, das in der bestimmten Speicherzelle gespeicherte Prüfmuster zu lesen, und die in dem Zwischenspeicher gespeicherten Daten in die bestimmte Speicherzelle zurück zu schreiben.

Das Prüfmuster kann aus einer Auswahl vorbestimmter Prüfmuster durch die Testeinrichtung ausgewählt werden.

Bei einer weiteren Ausführungsform ist die Testeinrichtung dazu eingerichtet, ein Prüfergebnis in Abhängigkeit des von der bestimmten Speicherzelle gelesenen Prüfmusters zu bestimmen und das bestimmte Prüfergebnis an die Steuereinrichtung zu übertragen.

Zur Bestimmung des Prüfergebnisses wird die Testeinrichtung insbesondere das von der bestimmten Speicherzelle gelesene Prüfmuster mit dem in die bestimmte Speicherzelle geschriebenen Prüfmuster vergleichen.

Bei einer weiteren Ausführungsform ist die Steuereinrichtung dazu eingerichtet, eine Sicherheitsmaßnahme zur Gewährleistung der Systemsicherheit in Abhängigkeit des von der Testeinrichtung übertragenen Prüfergebnisses durchzuführen.

Bei einer weiteren Ausführungsform wählt die Steuereinrichtung bei Vorliegen eines bestimmten Prüfergebnisses eine bestimmte Sicherheitsmaßnahme aus einer Mehrzahl vorbestimmter Sicherheitsmaßnahmen aus und führt diese anschließend aus.

Die Mehrzahl der vorbestimmten Sicherheitsmaßnahmen umfasst beispielsweise ein Stromlosschalten der Vorrichtung, ein Spannungsfreischalten der Vorrichtung und/oder ein sicheres Herunterfahren der Vorrichtung.

Bei einer weiteren Ausführungsform sind die Steuereinrichtung und die Testeinrichtung auf einer einzigen integrierten Schaltung, insbesondere auf einem Chip, integriert.

Bei einer weiteren Ausführungsform sind die Testeinrichtung und der Speicher auf einer einzigen integrierten Schaltung integriert.

Bei einer weiteren Ausführungsform sind die Steuereinrichtung, die Testeinrichtung und der Speicher auf einer einzigen integrierten Schaltung integriert.

Bei einer weiteren Ausführungsform ist die Testeinrichtung dazu eingerichtet, die Speicherzellen des Speichers zyklisch zu testen.

Hierdurch werden automatisierte zyklische Speichertests, wie beispielsweise zyklische RAM-Tests für Microcontroller-Systeme, ermöglicht.

Ferner wird ein elektrisches Gerät mit einem Speicher vorgeschlagen, welches eine wie oben beschriebene erfindungsgemäße Vorrichtung zum Testen des Speichers aufweist.

Das elektrische Gerät ist beispielsweise eine Handwerkzeugmaschine oder ein Akkumulator für eine Handwerkzeugmaschine. Die Handwerkzeugmaschine ist insbesondere eine elektrische Handwerkzeugmaschine, wie zum Beispiel ein Elektroschrauber.

Der Elektroschrauber hat ein Gehäuse mit einem Handgriff, mittels welchem ein Anwender den Elektroschrauber halten und führen kann. Ein Taster an dem Handgriff ermöglicht dem Anwender den Elektroschrauber in Betrieb zu nehmen. Beispielsweise muss der Anwender den Taster durchgehend gedrückt halten, um den Elektroschrauber in Betrieb zu halten.

Der Elektroschrauber hat eine Werkzeugaufnahme, in welche der Anwender ein Schrauberbit einsetzen kann. Bei Betätigen des Tasters dreht ein Elektromotor die Werkzeugaufnahme um ihre Achse. Der Elektromotor ist über eine Spindel und ggf. weitere Komponenten eines Antriebsstrangs, z.B. Kupplung, Getriebe, mit der Werkzeugaufnahme gekoppelt.

Des Weiteren wird ein Verfahren zum Testen eines Speichers eines elektrischen Gerätes vorgeschlagen, welches eine mit dem Speicher gekoppelte Steuereinrichtung zum Steuern des elektrischen Gerätes aufweist.

Vor dem Testen einer bestimmten Speicherzelle einer Vielzahl von Speicherzellen des Speichers werden die in der bestimmten Speicherzelle gespeicherten Daten in einen Zwischenspeicher gespeichert. Anschließend wird die bestimmte Speicherzelle mittels einer mit dem Speicher gekoppelten Testeinrichtung getestet. Während des Testens der bestimmten Speicherzelle wird die Adresse der bestimmten Speicherzelle auf die Adresse des Zwischenspeichers umgesetzt. Folglich können der Steuereinrichtung bei einem Zugriff auf die Adresse der bestimmten Speicherzelle während des Speichertests die in dem Zwischenspeicher gespeicherten Daten bereitgestellt werden.

### KURZE BESCHREIBUNG DER FIGUREN

Die nachfolgende Beschreibung erläutert die Erfindung anhand von exemplarischen Ausführungsformen und Figuren. In den Figuren zeigt:
- Fig. 1: ein schematisches Blockschaltbild eines ersten Ausführungsbeispiels einer Vorrichtung zum Testen eines Speichers eines elektrischen Gerätes;
- Fig. 2: ein schematisches Blockschaltbild eines zweiten Ausführungsbeispiels einer Vorrichtung zum Testen eines Speichers eines elektrischen Gerätes;
- Fig. 3: ein schematisches Blockschaltbild eines Ausführungsbeispiels eines elektrischen Gerätes; und
- Fig. 4: ein schematisches Ablaufdiagramm eines Verfahrens zum Testen eines Speichers eines elektrischen Gerätes.

Gleiche oder funktionsgleiche Elemente werden durch gleiche Bezugszeichen in den Figuren indiziert, soweit nicht anders angegeben.

### AUSFÜHRUNGSFORMEN DER ERFINDUNG

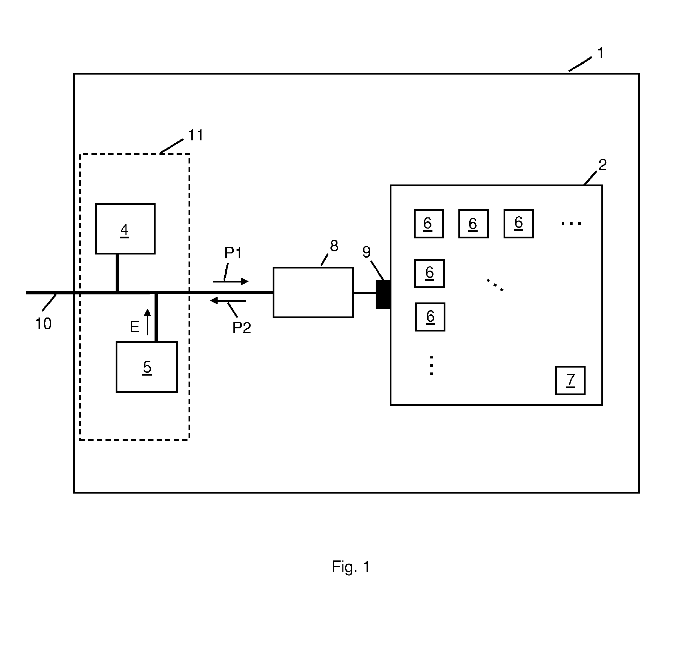

In Fig. 1 ist ein schematisches Blockschaltbild eines ersten Ausführungsbeispiels einer Vorrichtung 1 zum Testen eines Speichers 2 eines elektrischen Gerätes 3 dargestellt.

Die Vorrichtung 1 weist den Speicher 2, eine Steuereinrichtung 4 zum Steuern des elektrischen Gerätes 3 und eine Testeinrichtung 5 zum Testen des Speichers 2 auf. Der Speicher 2 hat eine Vielzahl von Speicherzellen 6 zum Speichern von Daten. Der Speicher 2 hat eine weitere Speicherzelle 7, welche als Zwischenspeicher dient. Die Speicherzelle 7 kann auch als Reserve-Zelle bezeichnet werden.

Ferner weist die Vorrichtung 1 einen Adressumsetzer 8 auf, der mit der Schnittstelle 9 des Speichers 2 gekoppelt ist. Der Adressumsetzer 8 ist des Weiteren mit der Steuereinrichtung 4 und der Testeinrichtung 5 über einen Kommunikationsbus 10 gekoppelt. Die Steuereinrichtung 4 und die Testeinrichtung 5 sind vorzugsweise auf einer einzigen integrierten Schaltung 11 integriert. Die Testeinrichtung 5 kann die Speicherzellen 6 des Speichers zyklisch testen. Die jeweils zu testende Speicherzelle 6 wird im Folgenden als bestimmte Speicherzelle oder Testzelle bezeichnet.

Zum Testen einer bestimmten Speicherzelle 6 ist die Testeinrichtung 5 dazu eingerichtet, die in der bestimmten Speicherzelle 6 gespeicherten Daten in den Zwischenspeicher 7 zu schreiben. Zumindest einmal beschreibt die Testeinrichtung 5 anschließend die bestimmte Speicherzelle 6 mit einem Prüfmuster P1. Das Prüfmuster P1 wird über den Kommunikationsbus 10, den Adressumsetzer 8 und die Schnittstelle 9 zu der bestimmtem Speicherzelle 6 des Speichers 2 übertragen. Nach Ablauf einer vorbestimmten Zeit wird das in der bestimmten Speicherzelle 6 gespeicherte Prüfmuster P2 von der Testeinrichtung 5 über die Schnittstelle 9, den Adressumsetzer 8 und den Kommunikationsbus 10 ausgelesen. Falls die bestimmte Speicherzelle 6 fehlerhaft ist, entspricht das gelesene Prüfmuster P2 nicht dem geschriebenen Prüfmuster P1. Die in dem Zwischenspeicher 7 gespeicherten ursprünglichen Daten der bestimmten Speicherzelle 6 werden in diese wieder zurück geschrieben. Durch Vergleichen des geschriebenen Prüfmusters P1 mit dem gelesenen Prüfmuster P2 kann die Testeinrichtung 5 ein Prüfergebnis E bestimmen. In Abhängigkeit eines festgestellten Unterschiedes zwischen dem gelesenen Prüfmuster P2 und dem geschriebenen Prüfmuster P1 kann die Testeinrichtung 5 vorzugsweise die Art und den Umfang eines Fehlers der bestimmten Speicherzelle 6 bestimmen. Die Art und der Umfang eines bestimmten Fehlers können Teil des Prüfergebnisses E sein.

Die Testeinrichtung 5 ist weiterhin dazu eingerichtet, das bestimmte Prüfergebnis E an die Steuereinrichtung 4 über den Kommunikationsbus 10 zu übertragen. Insbesondere ist die Testeinrichtung 58 dazu eingerichtet, an dem Kommunikationsbus 10 mitzuhören, ob die bestimmte Speicherzelle 6 unter Test von der Steuereinrichtung 4 gelesen oder geschrieben wird. In diesem Fall stellt die Testeinrichtung 5 die in dem Zwischenspeicher 7 gespeicherten Daten der Steuereinrichtung 4 bereit.

Die Steuereinrichtung 5 ist insbesondere dazu eingerichtet, eine Sicherheitsmaßnahme zur Gewährleistung der Systemssicherheit in Abhängigkeit des von der Testeinrichtung 5 übertragenen Prüfergebnisses E durchzuführen. Insbesondere in Abhängigkeit der bestimmten Art und des bestimmten Umfangs eines festgestellten Fehlers der bestimmten Speicherzelle 6 kann die Steuereinrichtung 4 eine bestimmte Sicherheitsmaßnahme aus einer Mehrzahl von vorbestimmten Sicherheitsmaßnahmen auswählen und anschließend durchführen. Beispielsweise wird bei Feststellung eines bestimmten Fehlers die Vorrichtung 1 stromlos geschaltet. Alternativ kann die Vorrichtung 1 auch sicher herunter gefahren werden.

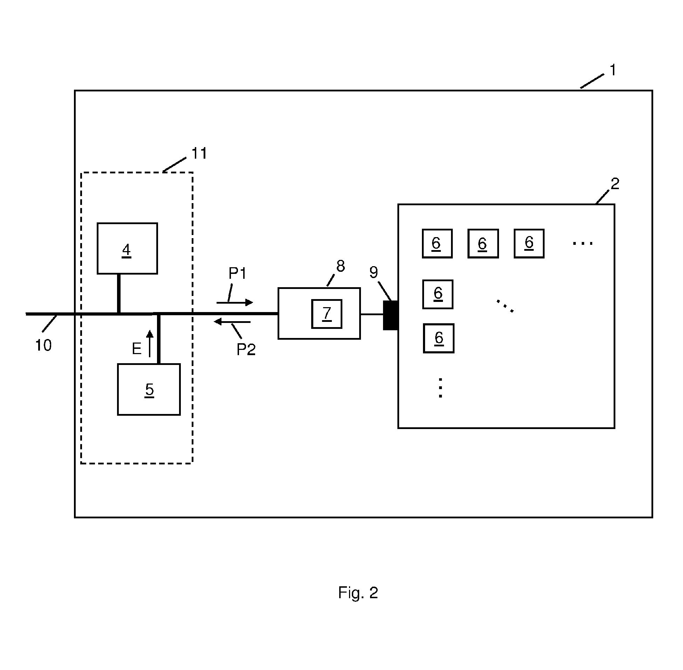

Fig. 2 zeigt ein schematisches Blockschaltbild eines zweiten Ausführungsbeispiels einer Vorrichtung 1 zum Testen eines Speichers 2 eines elektrischen Gerätes 3. Die Vorrichtung 1 der Fig. 2 unterscheidet sich von der Vorrichtung 1 nach Fig. 1 dahingehend, dass der Zwischenspeicher 7 nicht Teil des Speichers 2, sondern Teil des Adressumsetzers 8 ist.

Durch die Integration des Zwischenspeichers 7 in den Adressumsetzer 8 können alle Speicherzellen6 des Speichers 2 zum Speichern von Daten für die Steuereinrichtung 4 eingesetzt werden. Des Weiteren ergibt sich aus der Integration des Zwischenspeichers 7 in den Adressumsetzer 8, dass der Adressumsetzer 8 bei einem Zugriff der Steuereinrichtung 4 auf die Daten der bestimmten Speicherzelle 6 des Speichers 2 während des Speichertests nicht auf den Speicher 2 zugreifen muss, da der Adressumsetzer 8 diese Daten in dem integrierten Zwischenspeicher 7 bereits speichert. Hierdurch kann Zeit eingespart werden.

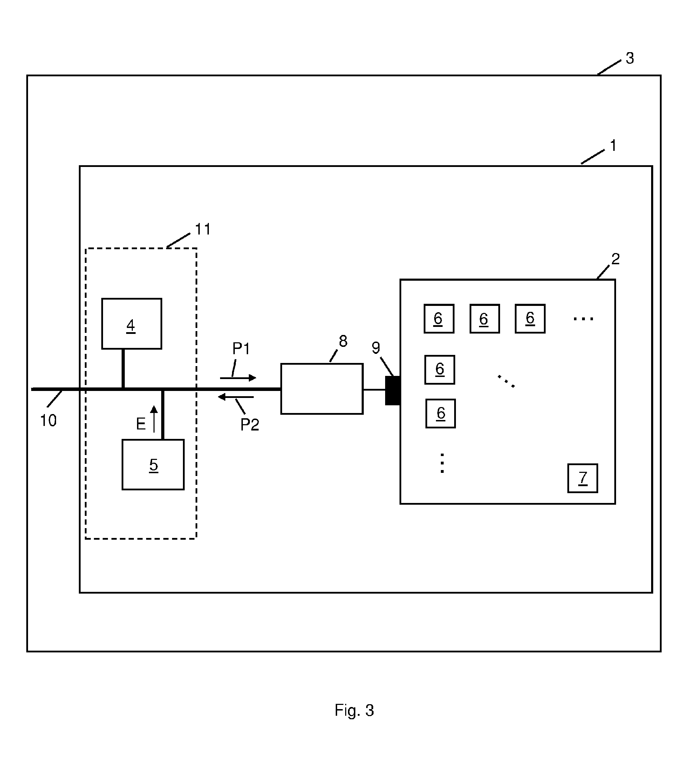

Fig. 3 zeigt ein schematisches Blockschaltbild eines Ausführungsbeispiels eines elektrischen Gerätes 3. Das elektrische Gerät 3 weist die Vorrichtung 1 nach Fig. 1 auf. Alternativ kann das elektrische Gerät 3 auch die Vorrichtung 1 nach Fig. 2 aufweisen. Das elektrische Gerät 3 ist beispielsweise eine Handwerkzeugmaschine, z.B. ein Elektroschrauber, Bohrmaschine, Bohrhammer, Winkelschleifer. Das elektrische Gerät 3 kann auch ein Akkumulator für eine Handwerkzeugmaschine sein.

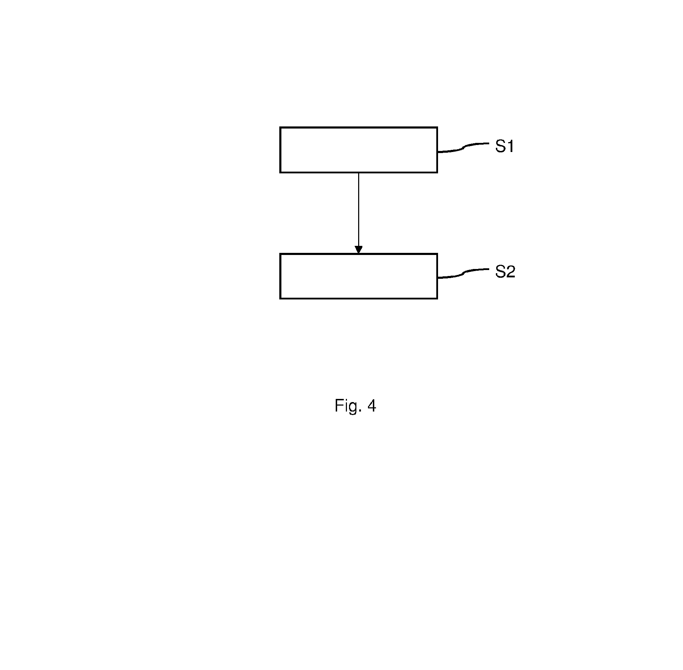

In Fig. 4 ist ein schematisches Ablaufdiagramm eines Verfahrens zum Testen eines Speichers 2 eines elektrischen Gerätes 3 dargestellt. Das elektrische Gerät 3 hat eine mit dem Speicher 2 gekoppelte Steuereinrichtung 4 zum Steuern des elektrischen Gerätes.

In Schritt S1 werden vor dem Testen einer bestimmten Speicherzelle 6 einer Vielzahl von Speicherzellen 6 des Speichers 2 die in der bestimmten Speicherzelle 6 gespeicherten Daten in einen Zwischenspeicher 7 gespeichert.

In Schritt S2 wird die bestimmte Speicherzelle 6 mittels einer mit dem Speicher 2 gekoppelten Testeinrichtung 5 getestet. Während des Testens der bestimmten Speicherzelle 6 wird die Adresse der bestimmten Speicherzelle 6 auf die Adresse des Zwischenspeichers 7 umgesetzt. Folglich können der Steuereinrichtung 4 bei einem Zugriff auf die Adresse der bestimmten Speicherzelle 6 während des Speichertests die in dem Zwischenspeicher 7 gespeicherten Daten bereitgestellt werden.

## Patentansprüche

1. Vorrichtung (1) zum Testen eines Speichers (2) eines elektrischen Gerätes (3), mit:
einer mit dem Speicher (2) gekoppelten Steuereinrichtung (4) zum Steuern des elektrischen Gerätes (3),
einer mit dem Speicher (2) gekoppelten Testeinrichtung (5) zum Testen einer bestimmten Speicherzelle (6) einer Vielzahl von Speicherzellen (6) des Speichers (2),
einem Zwischenspeicher (7) zum Zwischenspeichern der in der bestimmten Speicherzelle (6) gespeicherten Daten während des Testens der bestimmten Speicherzelle (6), und
einem Adressumsetzer (8) zum Umsetzen der Adresse der bestimmten Speicherzelle (6) auf die Adresse des Zwischenspeichers (7) während des Testens der bestimmten Speicherzelle (6).

2. Vorrichtung nach Anspruch 1, **dadurch gekennzeichnet, dass** der Speicher (2) eine einzige Schnittstelle (9) aufweist, über welche die Steuereinrichtung (4), die Testeinrichtung (5) und der Adressumsetzer (8) mit dem Speicher (2) gekoppelt sind.

3. Vorrichtung nach Anspruch 2, **dadurch gekennzeichnet, dass** der Adressumsetzer (8) zwischen der Schnittstelle (9) des Speichers (2) und der Steuereinrichtung (4) sowie zwischen der Schnittstelle (9) des Speichers (2) und der Testeinrichtung (5) gekoppelt ist.

4. Vorrichtung nach Anspruch 3, **dadurch gekennzeichnet, dass** ein Kommunikations-Bus (10) vorgesehen ist, über welchen die Steuereinrichtung (4), die Testeinrichtung (5) und der Adressumsetzer (8) gekoppelt sind.

5. Vorrichtung nach einem der vorhergehenden Ansprüche, **dadurch gekennzeichnet, dass** der Zwischenspeicher (7) als eine vorbestimmte Speicherzelle (6) des Speichers (2) ausgebildet ist.

6. Vorrichtung nach einem der Ansprüche 1 bis 4, **dadurch gekennzeichnet, dass** der Zwischenspeicher (7) in dem Adressumsetzer (8) integriert ist.

7. Vorrichtung nach einem der vorhergehenden Ansprüche, **dadurch gekennzeichnet, dass** die Testeinrichtung (5) zum Testen der bestimmten Speicherzelle (6) dazu eingerichtet ist, die in der bestimmten Speicherzelle (6) gespeicherten Daten in den Zwischenspeicher (7) zu speichern, die bestimmte Speicherzelle (6) mit einem Prüfmuster (P1) zu beschreiben, das in der bestimmten Speicherzelle (6) gespeicherte Prüfmuster (P2) zu lesen, und die in dem Zwischenspeicher (7) gespeicherten Daten in die bestimmte Speicherzelle (4) zurück zu schreiben.

8. Vorrichtung nach Anspruch 7, **dadurch gekennzeichnet, dass** die Testeinrichtung (5) dazu eingerichtet ist, ein Prüfergebnis (E) in Abhängigkeit des von der bestimmten Speicherzelle (6) gelesenen Prüfmusters (P2) zu bestimmen und das bestimmte Prüfergebnis (E) an die Steuereinrichtung (4) zu übertragen.

9. Vorrichtung nach Anspruch 8, **dadurch gekennzeichnet, dass** die Testeinrichtung (5) dazu eingerichtet ist, das Prüfergebnis (E) durch Vergleichen des von der bestimmten Speicherzelle (6) gelesenen Prüfmusters (P2) mit dem in die bestimmte Speicherzelle (6) geschriebenen Prüfmuster (P1) zu bestimmen.

10. Vorrichtung nach Anspruch 8 oder 9, **dadurch gekennzeichnet, dass** die Steuereinrichtung (4) dazu eingerichtet ist, eine Sicherheitsmaßnahme zur Gewährleistung der Systemsicherheit in Abhängigkeit des von der Testeinrichtung (5) übertragenen Prüfergebnisses (E) durchzuführen.

11. Vorrichtung nach Anspruch 10, **dadurch gekennzeichnet, dass** die Steuereinrichtung (4) dazu eingerichtet ist, bei Vorliegen eines bestimmten Prüfergebnisses (E) eine bestimmte Sicherheitsmaßnahme aus einer Mehrzahl vorbestimmter Sicherheitsmaßnahmen auszuwählen und durchzuführen.

12. Vorrichtung nach einem der vorhergehenden Ansprüche, **dadurch gekennzeichnet, dass** die Steuereinrichtung (4) und die Testeinrichtung (5) auf einer integrierten Schaltung (11) integriert sind.

13. Elektrisches Gerät (3) mit einer Vorrichtung (1) nach einem der Ansprüche 1 bis 12.

14. Elektrisches Gerät nach Anspruch 13, **dadurch gekennzeichnet, dass** das elektrische Gerät (3) eine Handwerkzeugmaschine oder ein Akkumulator für eine Handwerkzeugmaschine ist.

15. Verfahren zum Testen eines Speichers (2) eines elektrischen Gerätes (3), welches eine mit dem Speicher (2) gekoppelte Steuereinrichtung (4) zum Steuern des elektrischen Gerätes (3) aufweist, mit:
Testen einer bestimmten Speicherzelle (6) einer Vielzahl von Speicherzellen (6) des Speichers (2) mittels einer mit dem Speicher (2) gekoppelten Testeinrichtung (5),
Zwischenspeichern der in der bestimmten Speicherzelle (6) gespeicherten Daten in einem Zwischenspeicher (7) während des Testens der bestimmten Speicherzelle (6), und
Umsetzen der Adresse der bestimmten Speicherzelle (6) auf die Adresse des Zwischenspeichers (7) während des Testens der bestimmten Speicherzelle (6).
